# EUROPEAN PATENT SPECIFICATION

(11) **EP 4 575 539 B1**
(45) Date of publication and mention of the grant of the patent: **26.08.2026**
(21) Application number: 24832174.7
(22) Date of filing: 29.02.2024
(51) Int. Cl.: G01R 31/367, G01R 31/3828, G01R 31/3842, B60L 58/12, B60L 53/24

(54) **BATTERY MANAGEMENT SYSTEM, BATTERY PACK, ELECTRIC VEHICLE AND BATTERY MANAGEMENT METHOD**
BATTERIEVERWALTUNGSSYSTEM, BATTERIEPACK, ELEKTROFAHRZEUG UND BATTERIEVERWALTUNGSVERFAHREN
SYSTÈME DE GESTION DE BATTERIE, BLOC-BATTERIE, VÉHICULE ÉLECTRIQUE ET PROCÉDÉ DE GESTION DE BATTERIE

(30) Priority: 26.06.2023 KR 20230082153
(43) Date of publication of application: 25.06.2025
(73) Proprietor: LG Energy Solution, Ltd., Seoul 07335 (KR)
(72) Inventor: KO, Young-Hwi, Daejeon 34122 (KR)
(74) Representative: Plasseraud IP
(86) International application number: PCT/KR2024/002696
(87) International publication number: WO 2025/005386

(56) References cited:
- JP-A- 2019 184 316
- JP-A- 2019 184 316
- JP-A- 2019 219 193
- KR-A- 20190 040 412
- KR-A- 20210 049 338
- US-A1- 2022 176 845
- MUN YEJIN, KIM NAMHOON, RYU JIHOON, LEE KYUNGMIN, LEE JONGHYEOK, CHO WONHEE, KIM YEONSOO: "Simultaneous Estimation of State of Charge and Capacity using Extended Kalman Filter in Battery Systems", KOREAN CHEMICAL ENGINEERING RESEARCH, KOREAN INSTITUTE OF CHEMICAL ENGINEERS, KR, vol. 60, no. 3, 1 August 2022 (2022-08-01), KR , pages 363 - 370, XP093255539, ISSN: 0304-128X, DOI: 10.9713/kcer.2022.60.3.363

## Description

### TECHNICAL FIELD

The present disclosure relates to State Of Charge estimation in a battery.

The present application claims priority to Korean Patent Application No. 10-2023-0082153 filed in the Republic of Korea on June 26, 2023.

### BACKGROUND ART

Recently, there has been a dramatic increase in demand for portable electronic products such as laptop computers, video cameras and mobile phones, and with the extensive development of electric vehicles, accumulators for energy storage, robots and satellites, many studies are being made on high performance batteries that can be recharged repeatedly.

Currently, commercially available batteries include nickel-cadmium batteries, nickel-hydrogen batteries, nickel-zinc batteries, lithium batteries and the like, and among them, lithium batteries have little or no memory effect, and thus they are gaining more attention than nickel-based batteries for their advantages that recharging can be done whenever it is convenient, the self-discharge rate is very low and the energy density is high.

One of the important parameters required to control the charge and discharge of a battery is a state of charge (SOC). The SOC is a parameter indicating a relative ratio of the current capacity to the maximum capacity indicating the total electrical energy when the battery is fully charged, and may be represented as 0 to 1 (or 0% to 100%). For example, when the maximum capacity of the battery is 1000 Ah (ampere-hour), and the capacity currently stored in the battery is 750 Ah, the SOC of the battery is 0.75 (or 75%).

To estimate the SOC of the battery, the extended Kalman filter (EKF) is widely used.

The extended Kalman filter is an SOC estimation logic using an equivalent circuit model (ECM) and an SOC-Open Circuit Voltage (OCV) curve, each prepared beforehand according to electrical and chemical properties of the battery, and outputs an estimated SOC that is one of state variables when inputting a voltage and a current of the battery as input variables.

Meanwhile, some types of batteries such as lithium iron phosphate (LFP) batteries have a voltage variation section in the SOC-OCV curve. An SOC-Closed Circuit Voltage (CCV) curve obtained by repeatedly measuring a terminal voltage of the battery in a constant current charge mode and/or a constant current discharge mode has a more indistinct voltage variation section than the SOC-OCV curve. As the current rate is higher, the voltage variation section fades away or disappears completely.

To fully reflect the characteristics of the voltage variation section of the battery on the EKF, it is necessary to precisely design the ECM. However, as the design precision of the ECM increases, the number of devices included in the ECM increases so much, and a connection relationship between the devices becomes complex, resulting in increased complexity and data storage space required for SOC estimation. Additionally, despite high design precision of the ECM, it is difficult to fully reflect the voltage variation section that changes depending on the current rate.

To solve the problem caused by the ECM constraints, an approach to estimate the SOC of the battery in a constant current charge/discharge mode using ampere counting rather than EKF may be contemplated. The ampere counting refers to the technique that estimates the SOC of the battery by converting an accumulated value of the current flowing through the battery to a change in SOC. However, when the constant current charge/discharge mode lasts for a long time, a current measurement error also accumulates over time, resulting in low accuracy in SOC estimation by ampere counting.

US 2022/176845 A1 relates to technology for estimating a State Of Charge of each of a plurality of battery cells.

### SUMMARY

### Technical Problem

The present disclosure is designed to solve the above-described problem, and therefore the present disclosure is directed to a battery pack for estimating a state of charge of a battery having a characteristic that a voltage variation section changes depending on a current rate by using two extended Kalman filters having a complementary relationship in parallel, an electric vehicle including the battery pack and a battery management method.

These and other objectives and advantages of the present disclosure may be understood by the following description and will be apparent from the embodiments of the present disclosure. In addition, it will be easily understood that the objectives and advantages of the present disclosure may be realized by the means set forth in the appended claims and a combination thereof.

### Technical Solution

A battery management system according to an aspect of the present invention is for a battery having a characteristic that a voltage variation section changes depending on a current rate. The battery management system includes a sensing unit configured to detect a terminal voltage and a charge/discharge current of the battery, a memory unit configured to store a first Kalman filter which is a state of charge (SOC) estimation logic using an equivalent circuit model and an SOC-open circuit voltage (OCV) curve of the battery and a second Kalman filter which is an SOC estimation logic using a constant current charge/discharge map of the battery, and a control unit configured to determine a voltage value of the detected terminal voltage and a current value of the detected charge/discharge current. The control unit is configured to determine a first estimated SOC by inputting the voltage value, the current value and an estimated SOC in a previous cycle to the first Kalman filter, and determine a second estimated SOC by inputting the current value and the estimated SOC in the previous cycle to the second Kalman filter. The control unit is configured to determine an SOC of the battery in a current cycle based on at least one of the first estimated SOC or the second estimated SOC.

The control unit may be configured to determine whether the battery is in a first state in which the battery is not being charged/discharged at a constant current or a second state in which the battery is being charged/discharged at the constant current based on the current value or current time-series data indicating a time-dependent change history of the charge/discharge current. The control unit may be configured to determine the SOC of the battery in the current cycle to be equal to the first estimated SOC in response to the determination that the battery is in the first state. The control unit may be configured to determine the SOC of the battery in the current cycle to be equal to the second estimated SOC in response to the determination that the battery is in the second state.

The control unit may be configured to determine whether the battery is in a first state in which the battery is not being charged/discharged at a constant current or a second state in which the battery is being charged/discharged at the constant current based on the current value or current time-series data indicating a time-dependent change history of the charge/discharge current. The control unit may be configured to determine a first weight having a positive correlation to a duration of the first state and a second weight having a negative correlation to the duration of the first state in response to the determination that the battery is in the first state. The control unit may be configured to determine the SOC of the battery in the current cycle to be equal to a weighted average of the first estimated SOC and the second estimated SOC by the first weight and the second weight.

The first weight may be larger than the second weight. A sum of the first weight and the second weight may be 1.

The control unit may be configured to determine whether the battery is in a first state in which the battery is not being charged/discharged at a constant current or a second state in which the battery is being charged/discharged at the constant current based on the current value or current time-series data indicating a time-dependent change history of the charge/discharge current. The control unit may be configured to determine a third weight having a negative correlation to a duration of the second state and a fourth weight having a positive correlation to the duration of the second state in response to the determination that the battery is in the second state. The control unit may be configured to determine a weight average of the first estimated SOC and the second estimated SOC by the third weight and the fourth weight as the SOC of the battery in the current cycle.

The third weight may be smaller than the fourth weight. A sum of the third weight and the fourth weight may be 1.

The constant current charge/discharge map may include a plurality of charge curves indicating a relationship between the SOC and the voltage of the battery during constant current charging using a plurality of current rates, and a plurality of discharge curves indicating a relationship between the SOC and the voltage of the battery during constant current discharging using the plurality of current rates.

The second estimated SOC may be outputted from the second Kalman filter in response to any one curve of the plurality of charge curves and the plurality of discharge curves being provided to the second Kalman filter.

The control unit may be configured to provide the second Kalman filter with any one charge curve associated with the current rate corresponding to the current value among the plurality of charge curves in response to the battery being charged at the constant current. The control unit may be configured to provide the second Kalman filter with any one discharge curve associated with the current rate corresponding to the current value among the plurality of discharge curves in response to the battery being discharged at the constant current.

A battery pack according to another aspect of the present disclosure includes the battery management system.

An electric vehicle according to still another aspect of the present disclosure includes the battery pack.

A battery management method according to yet another aspect of the present invention is for a battery having a characteristic that a voltage variation section changes depending on a current rate. The battery management method includes detecting a terminal voltage and a charge/discharge current of the battery, determining a voltage value of the detected terminal voltage and a current value of the detected charge/discharge current, determining a first estimated SOC by inputting the voltage value, the current value and an estimated SOC in a previous cycle to a first Kalman filter which is an SOC estimation logic using an equivalent circuit model and an SOC-OCV curve of the battery, determining a second estimated SOC by inputting the current value and the estimated SOC in the previous cycle to a second Kalman filter which is an SOC estimation logic using a constant current charge/discharge map of the battery, and determining an SOC of the battery in a current cycle based on at least one of the first estimated SOC or the second estimated SOC.

The determining of the SOC of the battery in the current cycle may include determining whether the battery is in a first state in which the battery is not being charged/discharged at a constant current or a second state in which the battery is being charged/discharged at the constant current based on the current value or current time-series data indicating a time-dependent change history of the charge/discharge current, determining the first estimated SOC as the SOC of the battery in the current cycle in response to the determination that the battery is in the first state, and determining the second estimated SOC as the SOC of the battery in the current cycle in response to the determination that the battery is in the second state.

The determining of the SOC of the battery in the current cycle may include determining whether the battery is in a first state in which the battery is not being charged/discharged at a constant current or a second state in which the battery is being charged/discharged at the constant current based on the current value or current time-series data indicating a time-dependent change history of the charge/discharge current, determining a first weight having a positive correlation to a duration of the first state and a second weight having a negative correlation to the duration of the first state in response to the determination that the battery is in the first state, and determining a weighted average of the first estimated SOC and the second estimated SOC by the first weight and the second weight as the SOC of the battery in the current cycle.

The determining of the SOC of the battery in the current cycle may include determining whether the battery is in a first state in which the battery is not being charged/discharged at a constant current or a second state in which the battery is being charged/discharged at the constant current based on the current value or current time-series data indicating a time-dependent change history of the charge/discharge current, determining a third weight having a negative correlation to a duration of the second state and a fourth weight having a positive correlation to the duration of the second state in response to the determination that the battery is in the second state, and determining a weighted average of the first estimated SOC and the second estimated SOC by the third weight and the fourth weight as the SOC of the battery in the current cycle.

The constant current charge/discharge map may include a plurality of charge curves indicating a relationship between the SOC and the voltage of the battery during constant current charging using a plurality of current rates, and a plurality of discharge curves indicating a relationship between the SOC and the voltage of the battery during constant current discharging using the plurality of current rates.

The second estimated SOC may be outputted from the second Kalman filter in response to any one curve of the plurality of charge curves and the plurality of discharge curves being provided to the second Kalman filter.

### Advantageous Effects

According to at least one of the embodiments of the present disclosure, two extended Kalman filters having a complementary relationship are used in parallel to estimate the SOC of the battery having a characteristic that the voltage variation section changes depending on the current rate, in order to reduce the SOC estimation error with change in charge/discharge mode of the battery, compared to a single extended Kalman filter, thereby improving SOC estimation accuracy.

The effects of the present disclosure are not limited to the above-mentioned effects, and these and other effects will be clearly understood by those skilled in the art from the appended claims.

### BRIEF DESCRIPTION OF THE DRAWINGS

The accompanying drawings illustrate exemplary embodiment of the present disclosure, and together with the following detailed description, serve to provide a further understanding of the technical aspect of the present disclosure, and thus the present disclosure should not be construed as being limited to the drawings.
FIG. 1 is a diagram exemplarily showing a configuration of an electric vehicle according to the present disclosure.
FIG. 2 is a diagram showing an exemplary equivalent circuit model of a battery shown in FIG. 1.
FIG. 3 is a diagram exemplarily showing a State of Charge (SOC)-Open Circuit Voltage (OCV) curve of a battery shown in FIG. 1.
FIG. 4 is a diagram used as a reference in describing a constant current charge/discharge map according to the present disclosure.
FIG. 5 is a flowchart exemplarily showing a battery management method for SOC estimation according to a first embodiment of the present disclosure.
FIG. 6 is a flowchart exemplarily showing a battery management method for SOC estimation according to a second embodiment of the present disclosure.
FIG. 7 is a flowchart exemplarily showing a battery management method for SOC estimation according to a third embodiment of the present disclosure.
FIG. 8 is a diagram used as a reference in describing the method according to FIG. 7.
FIG. 9 is a flowchart exemplarily showing a battery management method for SOC estimation according to a fourth embodiment of the present disclosure.
FIG. 10 is a diagram used as a reference in describing the method according to FIG. 9.
FIG. 11 is a flowchart exemplarily showing a battery management method for SOC estimation according to a fifth embodiment of the present disclosure.
FIG. 12 is a flowchart exemplarily showing a method for determining whether a battery is being charged/discharged at a constant current.

### DETAILED DESCRIPTION

Hereinafter, exemplary embodiments of the present disclosure will be described in detail with reference to the accompanying drawings. Prior to the description, it should be understood that the terms or words used in the specification and the appended claims should be interpreted based on the meanings and concepts corresponding to the technical aspect of the present disclosure.

Therefore, the embodiments described herein and illustrations shown in the drawings are provided to describe the exemplary embodiments of the present disclosure by way of example, but not intended to fully describe the technical aspect of the present disclosure, so it should be understood that a variety of other modifications could have been made thereto at the time the application was filed.

The terms including the ordinal number such as "first", "second" and the like, are used to distinguish one element from another among various elements, but not intended to limit the elements by the terms.

Unless the context clearly indicates otherwise, it will be understood that the term "comprises" when used in this specification, specifies the presence of stated elements, but does not preclude the presence or addition of one or more other elements. Additionally, the term "control unit" as used herein refers to a processing unit of at least one function or operation, and may be implemented by hardware or software alone or in combination.

In addition, throughout the specification, it will be further understood that when an element is referred to as being "connected to" another element, it can be directly connected to the other element or intervening elements may be present.

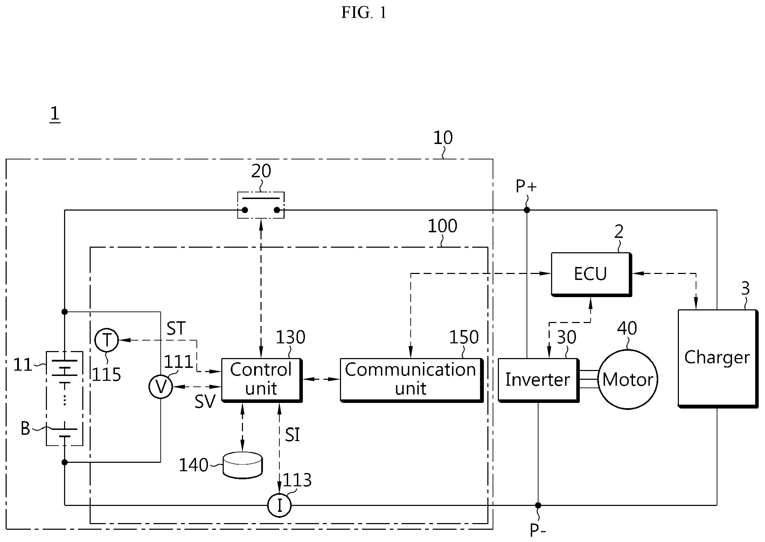

FIG. 1 is a diagram exemplarily showing a configuration of an electric vehicle according to the present disclosure.

The electric vehicle 1 includes a vehicle controller 2, a battery pack 10, a relay 20, an inverter 30 and an electric motor 40. Charge/discharge terminal P+, P- of the battery pack 10 may be electrically coupled to a charger 3 through a charge cable. The charger 3 may be included in the electric vehicle 1 or may be present at a charging station.

The vehicle controller 2 (for example, an Electronic Control Unit (ECU)) is configured to transmit a key-on signal to a battery management system 100 when a user switches a starter button (not shown) of the electric vehicle 1 to an ON-position. The vehicle controller 2 is configured to transmit a key-off signal to the battery management system 100 when the user switches the starter button to an OFF-position. The charger 3 may provide the charge power of constant current or constant voltage through the charge/discharge terminal P+, P- of the battery pack 10 via communication with the vehicle controller 2.

The battery pack 10 includes a battery module 11 and the battery management system 100.

The battery module 11 includes at least one battery B. The battery B can be recharged repeatedly. Additionally, the battery B is not limited to a particular type and may include any battery having a characteristic that a voltage variation section changes depending on a current rate like lithium iron phosphate (LFP) batteries.

When the battery module 11 includes a plurality of batteries, the plurality of batteries may be connected in series, in parallel, or in series and in parallel.

The relay 20 is electrically connected in series to the battery module 11 through a power path connecting the battery module 11 to the inverter 30. FIG. 1 shows the relay 20 connected between a positive terminal of the battery module 11 and the charge/discharge terminal P+. The relay 20 is controlled to turn on/off in response to the switching signal from the battery management system 100. The relay 20 may be a mechanical contactor that turns on or off by the magnetic force of a coil or a semiconductor switch such as Metal Oxide Semiconductor Field Effect transistor (MOSFET).

The inverter 30 is configured to convert the direct current from the battery module 11 to alternating current in response to a command from the battery management system 100 or the vehicle controller 2.

The electric motor 40 operates using the alternating current from the inverter 30. The electric motor 40 may include, for example, a 3-phase alternating current motor 40.

The battery management system 100 includes a voltage detection unit 111, a current detection unit 113, a temperature detection unit 115 and a control unit 130. The battery management system 100 may further include a communication circuit 150.

The voltage detection unit 111 is connected to the positive and negative terminals of the battery B included in the battery module 11, and is configured to detect a terminal voltage across two terminals of the battery B, and output a voltage signal SV indicating the detected terminal voltage to the control unit 130.

The current detection unit 113 is connected in series to the battery module 11 through a current path between the battery module 11 and the inverter 30. The current detection unit 113 is configured to detect a charge/discharge current flowing through the battery module 11, and output a current signal SI indicating the detected charge/discharge current to the control unit 130. The current detection unit 113 may include one of known current detection devices such as, for example, a shunt resistor or a Hall-effect device or a combination thereof.

The temperature detection unit 115 is configured to detect a temperature of the battery B, and output a temperature signal ST indicating the detected temperature to the control unit 130. The temperature detection unit 115 may include one of known temperature detection devices such as, for example, a thermocouple, a thermistor or a bimetal, or a combination thereof.

The voltage detection unit 111, the current detection unit 113 and the temperature detection unit 115 may be referred to as a 'sensing unit'.

The communication circuit 150 is configured to support wired or wireless communication between the control unit 130 and the vehicle controller 2. The wired communication may be, for example, controller area network (CAN) communication, and the wireless communication may be, for example, Zigbee or Bluetooth communication. The communication protocol is not limited to a particular type and may include those that support the wired/wireless communication between the control unit 130 and the vehicle controller 2. The communication circuit 150 may include an output device (for example, a display, a speaker) to provide information received from the control unit 130 and/or the vehicle controller 2 into a recognizable format for the user.

The control unit 130 is operably coupled to the relay 20, the voltage detection unit 111, the current detection unit 113, the temperature detection unit 115 and the communication circuit 150. The operably coupled refers to direct/indirect connection to enable signal transmission and reception in one or two directions.

The control unit 130 may collect the voltage signal SV from the voltage detection unit 111, the current signal SI from the current detection unit 113 and/or the temperature signal ST from the temperature detection unit 115. The control unit 130 may convert and record each of the analog signals collected from the detection units 111, 113, 115 to a digital value by using an Analog to Digital Converter (ADC) within the control unit 130.

The control unit 130 may be referred to as a 'control circuit' or a 'battery controller', and may be implemented in hardware using at least one of application specific integrated circuits (ASICs), digital signal processors (DSPs), digital signal processing devices (DSPDs), programmable logic devices (PLDs), field programmable gate arrays (FPGAs), microprocessors or electrical units for performing other functions.

A memory unit 140 may include, for example, at least type of storage medium of flash memory type, hard disk type, Solid State Disk (SSD) type, Silicon Disk Drive (SDD) type, multimedia card micro type, random access memory (RAM), static random access memory (SRAM), read-only memory (ROM), electrically erasable programmable read-only memory (EEPROM) or programmable read-only memory (PROM). The memory unit 140 may store data and programs required for the computation operation by the control unit 130. The memory unit 140 may store data indicating the results of the computation operation by the control unit 130. Although FIG. 1 shows that the memory unit 140 is physically independent from the control unit 130, the memory unit 140 may be included in the control unit 130.

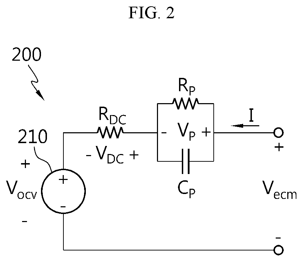

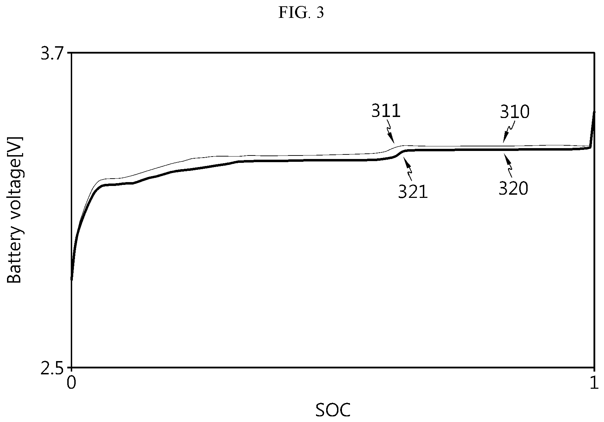

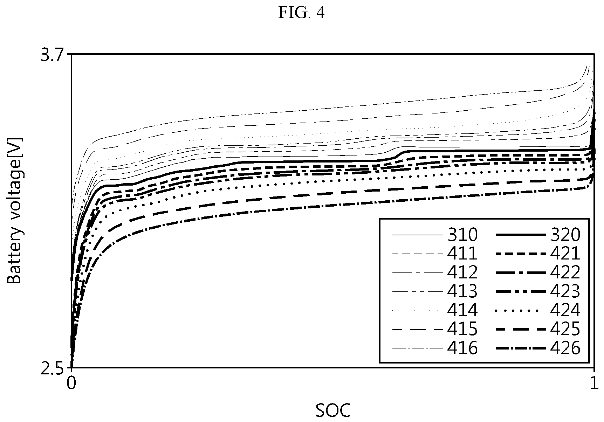

The memory unit 140 may store an equivalent circuit model (see FIG. 2), a State of Charge (SOC)-Open Circuit Voltage (OCV) curve (see FIG. 3), a constant current charge/discharge map (see FIG. 4), a first extended Kalman filter and a second extended Kalman filter. Each of the SOC-OCV curve, the constant current charge/discharge map, the first extended Kalman filter and the second extended Kalman filter will be described in more detail below.

The control unit 130 may turn on the relay 20 in response to the key-on signal. The control unit 130 may turn off the relay 20 in response to the key-off signal. The key-off signal indicates a switch from a cycle mode to a rest mode. Alternatively, the vehicle controller 2 may take responsibility for the on/off control of the relay 20, instead of the control unit 130.

While the relay 20 is turned on, the battery B of the battery module 11 enters the cycle mode. The cycle mode refers to an operational state in which the battery can be charged and discharged. The cycle mode may include a constant current charge mode, a constant current discharge mode and a non-constant current charge/discharge mode.

The constant current charge mode refers to a state in which a charge current of constant current rate flows in the battery B. The constant current discharge mode refers to a state in which a discharge current of constant current rate flows in the battery B. The non-constant current charge/discharge mode refers to a state in which a non-constant charge or discharge current flows in the battery B.

While the relay 20 is turned off, the battery B of the battery module **11** enters the rest mode. The rest mode refers to an operational state in which the charge/discharge current is interrupted and the battery cannot be charged and discharged.

**In** the specification, the battery B in a first operational state refers to the battery B in the rest mode or the non-constant current charge/discharge mode. The battery B in a second operational state refers to the battery B in the constant current charge mode or the constant current discharge mode.

While the battery module **11** is in the cycle mode, the control unit 130 may determine a voltage value, a current value and a temperature value based on the voltage signal SV, the current signal SI and the temperature signal ST, respectively, and determine (estimate) the SOC of the battery B based on the voltage value, the current value and/or the temperature value. The SOC refers to a ratio of the remaining capacity to the full charge capacity (the maximum capacity) of the battery B.

In the specification, SOC is indicated as a range between 0 and 1, SOC 0 refers to fully discharged state and SOC 1 refers to fully charged state.

In the specification, it is assumed that when U is a certain variable, 'U[k-1]' denotes a value of U in the previous cycle, and 'U[k]' denotes a value of U in the current cycle. The symbol k used together with the symbol [] is a time index that increases by 1 each time a predetermined period of time Δt (for example, 0.001 sec) has elapsed from the initial time point t₀.

At the initial time point t₀, k=0 may be set. For example, k = 10 indicates that Δt × 10 has elapsed from the initial time point t₀ and the estimated SOC was calculated 10 times during the period of time. The initial time point t₀ is a time point at which a predetermined event occurs, for example, an event of a switch of the control unit 130 from a sleep state to a wakeup state. The control unit 130 may be switched from the sleep state to the wakeup state in response to the key-on of the electric vehicle 1, and from the wakeup state to the sleep state in response to the key-off of the electric vehicle 1.

Hereinafter, the equivalent circuit model and the SOC-OCV curve used by the first extended Kalman filter will be described. The following Equation 1 to Equation 8 expresses the first extended Kalman filter, and in describing each of Equation 1 to Equation 8, the already described variables may be omitted to avoid redundancy.

The first extended Kalman filter uses a state equation (see the following Equation 4-1 and Equation 4-2) including SOC and polarization voltage as state variables, and the following Equation 1 represents a relationship between the SOC and the charge/discharge current by ampere counting. $SOC \left[k\right] = SOC \left[k-1\right] + \frac{Δt}{{Q}_{i}} I \left[k-1\right]$

In Equation 1, I[k-1] denotes the detected charge/discharge current in the previous cycle, Qᵢ denotes the maximum capacity of the battery B, SOC[k-1] denotes the SOC in the previous cycle, and SOC[k] denotes the SOC in the current cycle. I[0] = 0 A. Qᵢ denotes the maximum amount of charges that can be stored in the battery B. That is, the maximum capacity Qᵢ is equal to the accumulated value of the charge/discharge current from any one state of the fully charged state or the fully discharged state of the battery B until the other state.

Subsequently, FIG. 2 is a diagram showing the exemplary equivalent circuit model 200 of the battery B shown in FIG. 1, and FIG. 3 is a diagram exemplarily showing the SOC-OCV curve of the battery B shown in FIG. 1.

Referring to FIG. 2, the equivalent circuit model 200 includes a voltage source 210, a resistor R_{DC} and a RC pair R_{P}, C_{P}. The symbol I indicates the charge current.

The output voltage V_{OCV} of the voltage source 210 indicates the OCV of the battery B that was kept in the rest mode for a long time and reached an equilibrium.

FIG. 3 shows two SOC-OCV curves 310, 320. The SOC-OCV curve 310 shows a change in OCV of the battery B during charge cycles, and the SOC-OCV curve 320 shows a change in OCV of the battery B during discharge cycles. At the same SOC, the OCV in the SOC-OCV curve 310 is slightly higher than the OCV in the SOC-OCV curve 320, and this difference originates from hysteresis of the battery B during charge cycles and discharge cycles.

In any of the two SOC-OCV curves 310, 320, the SOC and OCV of the battery B have a non-linear positive correlation. That is, when f_{OCV} and f_{SOC} are inverse functions, OCV = f_{OCV}(SOC), SOC = f_{SOC}(OCV).

The SOC-OCV curves 310, 320 shown in FIG. 3 are associated with a specific temperature or a specific temperature range, and other SOC-OCV curve associated with other temperature or temperature range may be additionally stored in the memory unit 140.

Meanwhile, both the two SOC-OCV curves 310, 320 have a voltage variation section, i.e., an SOC range in which a change (may be an absolute value) of OCV with respect to SOC is equal to or more than a reference value. That is, in FIG. 3, the reference number 311 indicates the voltage variation section of the SOC-OCV curve 310, and the reference number 321 indicates the voltage variation section of the SOC-OCV curve 320.

The resistor R_{DC} is associated with an IR drop V_{DC} of the battery B. The IR drop V_{DC} is an instantaneous change in the terminal voltage across the battery B by the charge/discharge current. The memory unit 140 may record a first lookup table defining a correspondence between the SOC, the temperature and the resistor R_{DC}, and the control unit 130 may determine the resistor R_{DC} corresponding to the SOC and the temperature of the previous (or current) cycle from the first lookup table.

The RC pair refers to a parallel circuit of the resistor R_{P} and a capacitor C_{P}, and is associated with the polarization voltage (also known as 'over potential') V_{P} of the battery B. The time constant of the RC pair is the multiplication of the resistor R_{P} and the capacitor C_{P}. The memory unit 140 may record a second lookup table defining a correspondence between the SOC, the temperature and the RC pair R_{P}, C_{P}. The control unit 130 may determine the resistor R_{P} and the capacitor C_{P} corresponding to the SOC and the temperature of the previous (or current) cycle from the second lookup table. Determining the resistor R_{P} and the capacitor C_{P} may refer to determining the resistance of the resistor R_{P} and the capacitance of the capacitor C_{P}.

V_{ecm} is a variable indicating the voltage across the equivalent circuit model 200, and may indicate the estimated terminal voltage of the battery B. As shown in the following Equation 2-1, V_{ecm} may be the sum of the output voltage Vocv, the IR drop V_{DC} and the polarization voltage V_{P}. $\begin{matrix}{V}_{ecm} \left[k\right] = {V}_{OCV} \left[k\right] + {R}_{DC} \left[k\right] I \left[k\right] + {V}_{P} \left[k\right] \\ = {f}_{OCV} \left(SOC\left[k\right]\right) + {R}_{DC} \left[k\right] I \left[k\right] + {V}_{P} \left[k\right]\end{matrix}$

In Equation 2-1, R_{DC}[k] is the resistance of the resistor R_{DC} in the current cycle, I[k] is the measured charge/discharge current in the current cycle, V_{OCV}[k] is the estimated OCV in the current cycle, and V_{P}[k] is the estimated polarization voltage in the current cycle. Equation 2-1 may be represented by the following Equation 2-2. $\begin{matrix}{V}_{ecm} \left[k\right] = \left(c\left[k\right] 1\right) \left(\begin{matrix}SOC \left[k\right] \\ {V}_{P} \left[k\right]\end{matrix}\right) + {R}_{DC} \left[k\right] I \left[k\right] \\ = C \left[k\right] \left(\begin{matrix}SOC \left[k\right] \\ {V}_{P} \left[k\right]\end{matrix}\right) + {R}_{DC} \left[k\right] I \left[k\right]\end{matrix}$

In Equation 2-2, C[k] is a system matrix having the two components c[k] and 1. c[k] is a conversion factor from SOC[k] to V_{OCV}[k] by the function f_{OCV}. That is, the multiplication of c[k] and SOC[k] is equal to [k].

In the equivalent circuit model 200, the polarization voltage V_{P} may be calculated (estimated) using Equation 3-1 or Equation 3-2 below. ${V}_{P} \left[k\right] = {V}_{P} \left[k-1\right] - \frac{{V}_{P} \left[k-1\right]}{τ} Δt + \frac{I \left[k\right]}{{C}_{P}} Δt$ ${V}_{P} \left[k\right] = {V}_{P} \left[k-1\right] {e}^{- \frac{Δt}{τ}} + {R}_{P} \left[k\right] I \left[k\right] \left(1-{e}^{- \frac{Δt}{τ}}\right)$

In Equation 3-1 and Equation 3-2, V_{P}[k] denotes the polarization voltage in the current cycle, V_{P}[k-1] denotes the polarization voltage in the previous cycle, τ denotes the time constant of the RC pair R_{P}, C_{P}, and R_{P}[k] denotes the resistance of the resistor R_{P} in the current cycle. τ may be the multiplication of one of R_{P}[k-1] and R_{P}[k] and one of C_{P}[k-1] and C_{P}[k]. V_{P}[0] may be set to 0 V.

Hereinafter, the first extended Kalman filter will be described in detail. The state equation of the first extended Kalman filter may be represented by Equation 4-1 or Equation 4-2 below. Equation 4-1 is associated with Equation 1 and Equation 3-1, and Equation 4-2 is associated with Equation 1 and Equation 3-2. $\begin{matrix}{{x}_{∧}}^{-} \left[k\right] = \left(\begin{matrix}{{SOC}_{∧}}^{-} \left[k\right] \\ {{V}_{P}}^{-} \left[k\right]\end{matrix}\right) = {f}_{1} \left({x}_{∧}\left[k-1\right]\right) + {B}_{1} i \left[k\right] = \left(\begin{matrix}1 & 0 \\ 0 & 1 - \frac{Δt}{τ}\end{matrix}\right) {x}_{∧} \left[k-1\right] + \left(\begin{matrix}\frac{Δt}{{Q}_{i}} \\ \frac{Δt}{{C}_{P}}\end{matrix}\right) i \left[k\right] \\ = \left(\begin{matrix}1 & 0 \\ 0 & 1 - \frac{Δt}{τ}\end{matrix}\right) \left(\begin{matrix}{SOC}_{∧} \left[k-1\right] \\ {{V}_{P}}_{∧} \left[k-1\right]\end{matrix}\right) + \left(\begin{matrix}\frac{Δt}{{Q}_{i}} \\ \frac{Δt}{{C}_{P}}\end{matrix}\right) i \left[k\right]\end{matrix}$ $\begin{matrix}{\text{x}}_{∧} {}^{-} \left[\text{k}\right] = \left(\begin{matrix}{\text{SOC}}_{∧} {}^{-} \left[\text{k}\right] \\ {\text{V}}_{\text{P}} {{}_{∧}}^{-} \left[\text{k}\right]\end{matrix}\right) = {\text{f}}_{1} \left({\text{x}}_{∧} \left[\text{k} - 1\right]\right) + {\text{B}}_{1} \text{i} \left[\text{k}\right] \\ = \left(\begin{matrix}1 & 0 \\ 0 & {\text{e}}^{- \frac{\text{Δ} \text{t}}{\text{τ}}}\end{matrix}\right) {\text{x}}_{∧} \left[\text{k} - 1\right] + \left(\begin{matrix}\frac{\text{Δ} \text{t}}{{\text{Q}}_{\text{i}}} \\ {\text{R}}_{\text{P}} \left[\text{k}\right] \left(1 - {\text{e}}^{- \frac{\text{Δ} \text{t}}{\text{τ}}}\right)\end{matrix}\right) \text{i} \left[\text{k}\right] \\ = \left(\begin{matrix}1 & 0 \\ 0 & {\text{e}}^{- \frac{\text{Δ} \text{t}}{\text{τ}}}\end{matrix}\right) \left(\begin{matrix}{\text{SOC}}_{∧} \left[\text{k} - 1\right] \\ {\text{V}}_{\text{P} ∧} \left[\text{k} - 1\right]\end{matrix}\right) + \left(\begin{matrix}\frac{\text{Δ} \text{t}}{{\text{Q}}_{\text{i}}} \\ {\text{R}}_{\text{P}} \left[\text{k}\right] \left(1 - {\text{e}}^{- \frac{\text{Δ} \text{t}}{\text{τ}}}\right)\end{matrix}\right) \text{i} \left[\text{k}\right]\end{matrix}$

In Equation 4-1 and Equation 4-2, SOC_{^}[k-1] denotes the estimated SOC in the previous cycle, V_{P^}[k-1] denotes the estimated polarization voltage in the previous cycle, Qᵢ denotes the maximum capacity of the battery B, and τ denotes the time constant of the RC pair R_{P}, C_{P}. x_{^}⁻[k] is a state matrix of the current cycle, and SOC_{^}⁻[k] and V_{P^}⁻[k] included therein are state variables indicating the estimated SOC and polarization voltage in the current cycle, respectively.

The following Equation 5 is a time update equation of the first extended Kalman filter. ${P}^{-} \left[k\right] = {A}_{1} P \left[k-1\right] {{A}_{1}}^{T} + W = {A}_{1} P \left[k-1\right] {{A}_{1}}^{T} + \left(\begin{matrix}{W}_{1} & 0 \\ 0 & {W}_{2}\end{matrix}\right)$

In Equation 5, P[k-1] denotes an estimated error covariance matrix in the previous cycle, W denotes a process noise covariance matrix, and P⁻[k] denotes an estimated error covariance matrix in the current cycle. In Equation 5, A₁ is the Jacobian of the function f₁ in Equation 4-1 and Equation 4-2. The Jacobian A₁ may be represented by Equation 5-1 below. ${A}_{1} ≡ {\left.\frac{\partial {f}_{1}}{\partial x}\right|}_{x = {{x}_{∧}}^{-} \left[k\right]}$

A₁^{T} is a transposed matrix of A₁. Where k=0, P[0]=[ 1 0 ; 0 1 ]. When the time update process using Equation 4-1 or Equation 4-2 and Equation 5 is completed, the control unit 130 performs a measurement update process.

The following Equation 6 is a first measurement update equation of the first extended Kalman filter. $K \left[k\right] = {P}^{-} \left[k\right] {{H}_{1}}^{T} {\left({H}_{1}{P}^{-}\left[k\right]{{H}_{1}}^{T}+L\right)}^{- 1}$

In Equation 6, K[k] is the Kalman gain of the current cycle, H₁ is the Jacobian of the function h₁ according to the following Equation 6-1, H₁^{T} is a transposed matrix of H₁, and L is a measurement noise covariance matrix.

In relation to Equation 6, a terminal voltage estimation equation (an output equation) of Equation 6-1 below may be derived by associating the state matrix (x_{^}⁻[k]) with Equation 2-1. ${h}_{1} \left({{x}_{∧}}^{-}\left[k\right]\right) = {f}_{1} \left({x}_{∧}\left[k-1\right]\right) + {R}_{DC} \left[k\right] I \left[k\right] + {V}_{P} \left[k\right] = {z}_{∧} \left[k\right]$

The Jacobian H₁ in Equation 6 may be represented by Equation 6-2 below. ${H}_{1} ≡ {\left.\frac{\partial {h}_{1}}{\partial x}\right|}_{x = {{x}_{∧}}^{-} \left[k\right]}$

The following Equation 7 is a second measurement update equation of the first extended Kalman filter. $P \left[k\right] = {P}^{-} \left[k\right] - K \left[k\right] {H}_{1} {P}^{-} \left[k\right]$

In Equation 7, P[k] is the result of correcting P⁻[k] from Equation 5 by Equation 7.

The following Equation 8 is a third measurement update equation of the first extended Kalman filter. ${x}_{∧} \left[k\right] = \left(\begin{matrix}{SOC}_{∧} \left[k\right] \\ {V}_{{P}^{∧}} \left[k\right]\end{matrix}\right) = {{x}_{∧}}^{-} \left[k\right] + K \left[k\right] \left(z\left[k\right]-{z}_{∧}\left[k\right]\right)$

In Equation 8, z[k] is the detected terminal voltage in the current cycle, z_{^}[k] is the estimated terminal voltage in the current cycle, SOC_{^}[k] is the estimated SOC in the current cycle (referred to as a 'first estimated SOC' in the claims), and V_{P^}[k] is the estimated polarization voltage in the current cycle. x_{^}[k] of Equation 8 may be used as x_{^}[k-1] in Equation 4 in the next cycle.

When the first extended Kalman filter is operated by the control unit 130, the first estimated SOC indicating the current SOC of the battery B according to the above-described process is outputted from the first extended Kalman filter. The control unit 130 may operate the second extended Kalman filter in parallel while the first extended Kalman filter is in operation. That is, the first extended Kalman filter and the second extended Kalman filter may be operated at the same time.

Hereinafter, the constant current charge/discharge map will be described first, and then the second extended Kalman filter will be described in detail.

FIG. 4 is a diagram used as a reference in describing the constant current charge/discharge map 400 according to the present disclosure. The constant current charge/discharge map 400 includes a plurality of charge curves 411~416 and a plurality of discharge curves 421~426.

Each of the plurality of charge curves 411~416 indicates terminal voltage vs SOC of the battery B during constant current charge cycles using different current rates (also referred to as 'C-rate'). CCV may be a term that describes the measured terminal voltage of the battery B during charging or discharging. During charge cycles, as the current rate is higher, the CCV at the same SOC is higher.

Each of the plurality of discharge curves 421~416 indicates voltage (CCV) vs SOC of the battery B during constant current discharge cycles using different current rates. During discharge cycles, as the current rate is higher, the CCV at the same SOC is lower.

The plurality of charge curves 411~416 and the plurality of discharge curves 421~416 include six charge curves and six discharge curves, respectively, and the current rate is 0.05 C, 0.15 C, 0.25 C, 0.50 C, 1.00 C and 1.50 C in an ascending order. Each curve included in the constant current charge/discharge map 400 may be stored in the memory unit 140 in the form of a function.

To help understanding, FIG. 4 shows the plurality of charge curves 411~416 and the plurality of discharge curves 421~416 as well as the two SOC-OCV curves 310, 320 of FIG. 3. As can be seen through FIG. 4, as the current rate used during charge cycles increases, the voltage variation section present in the SOC-OCV curve 310 disappears gradually. Likewise, as the current rate used during discharge cycles increases, the voltage variation section present in the SOC-OCV curve 320 also disappears gradually.

As described above, it is not easy to design the equivalent circuit model 200 to accurately describe so-called fading, i.e., a phenomenon in which the voltage variation section disappears as the current rate increases. Additionally, when the equivalent circuit model 200 that does not accurately describe the fading characteristics at or above a predetermined level is used to estimate the SOC of the battery B during constant current charging or constant current discharging, there may be a big difference between the actual SOC and the estimated SOC.

Accordingly, to solve the above-described problem, during constant current charging or discharging, the SOC of the battery B may be estimated based on the output value of the second extended Kalman filter using the constant current charge/discharge map 400 rather than the output value of the first extended Kalman filter, or the SOC of the battery B may be estimated by combining (for example, a weighted average) the output value of the first extended Kalman filter with the output value from the second extended Kalman filter.

As opposed to the first extended Kalman filter using SOC and polarization voltage as its state variable, the second extended Kalman filter only uses SOC as its state variable, and may be represented by Equation 9 below. ${{x}_{∧}}^{-} \left[k\right] = {{SOC}_{∧}}^{-} \left[k\right] = {f}_{2} \left({x}_{∧}\left[k-1\right]\right) + {B}_{2} i \left[k\right] = {x}_{∧} \left[k-1\right] + \frac{Δt}{{Q}_{i}} i \left[k\right]$

In Equation 9, x_{^}[k-1] is the estimated SOC in the previous cycle, i[k] is the current value of the charge/discharge current detected in the current cycle, Qᵢ is the maximum capacity of the battery B, and x_{^}⁻[k] is the estimated SOC in the current cycle. x_{^}⁻[k] may be equal to SOC_{^}⁻[k] indicating the estimated SOC in the current cycle, and f₂(x_{^}[k-1]) may be equal to x_{^}[k-1].

The following Equation 10 is a time update equation of the second extended Kalman filter. ${P}^{-} \left[k\right] = {A}_{2} P \left[k-1\right] {{A}_{2}}^{T} + w$

In Equation 10, P[k-1] denotes the estimated error covariance in the previous cycle, w denotes the process noise covariance, and P⁻[k] denotes the estimated error covariance in the current cycle. A₂ is the Jacobian of the function f₂ of Equation 9. The Jacobian A₂ may be represented by Equation 10-1 below. ${A}_{2} ≡ {\left.\frac{\partial {f}_{2}}{\partial x}\right|}_{x = {{x}_{∧}}^{-} \left[k\right]}$

A₂^{T} is a transposed matrix of A₂. Where k=0, P[0] = 0. The control unit 130 performs a measurement update process when the time update process using Equation 9 and Equation 10 is completed.

The following Equation 11 is a first measurement update equation of the second extended Kalman filter. $K \left[k\right] = {P}^{-} \left[k\right] {{H}_{2}}^{T} {\left({H}_{2}{P}^{-}\left[k\right]{{H}_{2}}^{T}+l\right)}^{- 1}$

In Equation 11, K[k] is the Kalman gain in the current cycle, H₂ is the Jacobian of the function h₂ in the following Equation 11-1, H₂^{T} is a transposed matrix of H₂, and l is a measurement noise covariance.

In relation to Equation 11, as opposed to the first extended Kalman filter, the second extended Kalman filter uses the constant current charge/discharge map 400, so a terminal voltage estimation equation (an output equation) of Equation 12-1 below may be derived. ${h}_{2} \left({{x}_{∧}}^{-}\left[k\right]\right) = {f}_{CCV_I \left[k\right]} \left({{x}_{∧}}^{-}\left[k\right]\right) = {f}_{CCV_I \left[k\right]} \left({{SOC}_{∧}}^{-}\left[k\right]\right) = {z}_{∧} \left[k\right]$

In Equation 12-1, the function f_{CCV_I[k]} is a function that defines any one charge or discharge curve associated with the current rate corresponding to I[k] among the curves included in the constant current charge/discharge map 400. The control unit 130 selects any one charge curve corresponding to I[k] from the plurality of charge curves 411~416 in response to I[k] being the charge current. Selecting any one charge curve may refer to acquiring the function f_{CCV_I[k]} from the memory unit 140. Subsequently, the control unit 130 may set the estimated terminal voltage of the battery B in the current cycle so that the state variable (SOC_{^}⁻[k]) is equal to the output value (z_{^}[k]) of the function f_{CCV_I[k]} at the time of input.

Additionally, the Jacobian H in Equation 12-1 may be represented by the following Equation 12-2. ${H}_{2} ≡ {\left.\frac{\partial {h}_{2}}{\partial x}\right|}_{x = {{x}_{∧}}^{-} \left[k\right]}$

The following Equation 13 is a second measurement update equation of the second extended Kalman filter. $P \left[k\right] = {P}^{-} \left[k\right] - K \left[k\right] {H}_{2} {P}^{-} \left[k\right]$

In Equation 13, P[k] is the result of correcting P⁻[k] from Equation 10 by Equation 13.

The following Equation 14 is a third measurement update equation of the second extended Kalman filter. ${x}_{∧} \left[k\right] = {{x}_{∧}}^{-} \left[k\right] + K \left[k\right] \left(z\left[k\right]-{z}_{∧}\left[k\right]\right)$

In Equation 14, z[k] is the detected terminal voltage in the current cycle, z_{^}[k] is the estimated terminal voltage in the current cycle, and SOC_{^}[k] is the estimated SOC in the current cycle (referred to as a 'second estimated SOC' in the claims). x_{^}[k] by Equation 14 may be used as x_{^}[k-1] in Equation 9 in the next cycle.

The SOC estimation of the battery B by the first extended Kalman filter and the second extended Kalman filter has been hereinabove described.

The control unit 130 may determine the maximum capacity Qᵢ of the battery B that is the basic variable used by the first extended Kalman filter and the second extended Kalman filter by using Equation 15 below. ${Q}_{i} = \frac{ΔQ}{ΔSOC} = \frac{{\sum }_{j = a}^{b} I \left[j\right]}{{SOC}_{{i_}^{∧}} \left[b\right] - {SOC}_{{i_}^{∧}} \left[a\right]}$

In Equation 15, ΔSOC is a change in SOC for the capacity update period, and ΔQ is the accumulated value of the current by ampere counting for the capacity update period. In Equation 15, 'a' is a time index corresponding to the start time of the capacity update period, and 'b' is a time index corresponding to the end time of the capacity update period. The capacity update period may be may be the latest period during which ΔSOC is equal to or higher than a threshold change (for example, 0.5).

As the battery B degrades, the maximum capacity gradually reduces. Accordingly, when the degree of degradation of the battery B is above a predetermined level, the battery cell is highly likely to suddenly become inoperable, and accordingly it is necessary to estimate the SOC more precisely.

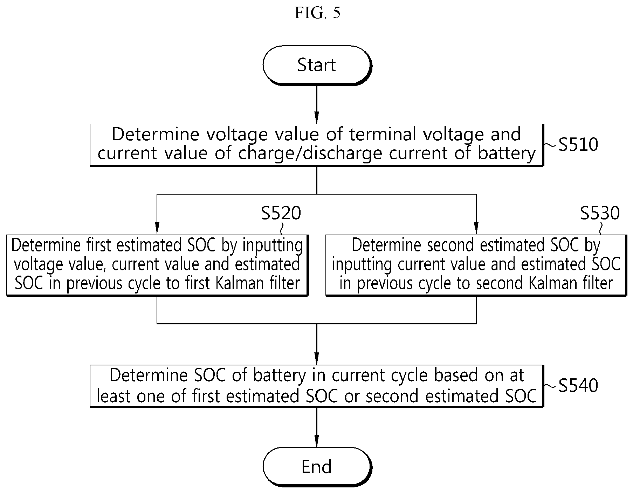

FIG. 5 is a flowchart exemplarily showing a battery management method for SOC estimation method according to a first embodiment of the present disclosure. The method of FIG. 5 may be repeatedly performed at a preset time interval from the time at which a predetermined event occurs.

Referring to FIGs. 1 to 5, in step S510, the control unit 130 detects the terminal voltage V[k] and the charge/discharge current I[k] of the battery B, and determines the voltage value V[k] of the terminal voltage and the current value I[k] of the charge/discharge current.

In step S520, the control unit 130 determines the first estimated SOC by inputting the voltage value V[k], the current value I[k] and the estimated SOC in the previous cycle to the first extended Kalman filter. The first extended Kalman filter is an SOC estimation logic using the equivalent circuit model 200 and the SOC-OCV curve 300 of the battery B. The first estimated SOC may be a candidate value indicating the SOC of the battery B in the current cycle. The voltage value V[k] of the terminal voltage may be used as z[k] in Equation 8. When the current value I[k] indicates the charging direction, the control unit 130 may provide the first extended Kalman filter with the SOC-OCV curve 310 among the two SOC-OCV curves 310, 320. In contrast, when the current value I[k] indicates the discharging direction, the control unit 130 may provide the first extended Kalman filter with the SOC-OCV curve 320 among the two SOC-OCV curves 310, 320.

In step S530, the control unit 130 determines the second estimated SOC by inputting the current value and the estimated SOC in the previous cycle to the second extended Kalman filter. The second extended Kalman filter is an SOC estimation logic using the constant current charge/discharge map 400 of the battery B. The second estimated SOC may be another candidate value indicating the SOC of the battery B in the current cycle. When the current value I[k] indicates the charging direction, the control unit 130 may provide the second extended Kalman filter with any one charge curve associated with the current rate corresponding to the current value I[k] among the plurality of charge curves 411~416. In contrast, when the current value I[k] indicates the discharging direction, the control unit 130 may provide the second extended Kalman filter with any one discharge curve associated with the current rate corresponding to the current value I[k] among the plurality of discharge curves 421~426.

When the time index k is 1, the average of two SOCs corresponding to the OCV at the initial time point t₀ in the two curves 310, 320 may be inputted to the first extended Kalman filter and the second extended Kalman filter as the estimated SOC in the previous cycle in the step S520 and the step S530.

In step S540, the control unit 130 determines the SOC of the battery B in the current cycle based on at least one of the first estimated SOC or the second estimated SOC.

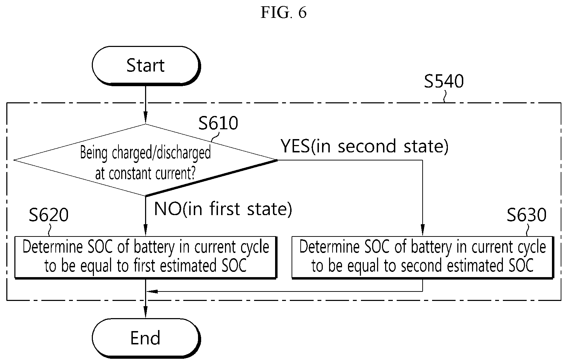

FIG. 6 is a flowchart exemplarily showing a battery management method for SOC estimation according to a second embodiment of the present disclosure. The method of FIG. 6 may be an example of a set of subroutines of the step S540 of the battery management method according to FIG. 5.

Referring to FIG. 6, in step S610, the control unit 130 determines whether the battery B is being charged/discharged at a constant current based on the current value I[k] or current time-series data indicating a time-dependent change history of the charge/discharge current. As an example, where the time index k=100, the current time-series data includes I[1]~I[100] as data points. A value of the step S610 being "NO" indicates a first state in which the battery B is not being charged/discharged at a constant current. When the value of the step S610 is "NO", the process moves to step S620. The value of the step S610 being "YES" indicates a second state in which the battery B is being charged/discharged at a constant current. When the value of the step S610 is "YES", the process moves to step S630.

In the step S620, the control unit 130 determines the SOC of the battery B in the current cycle to be equal to the first estimated SOC.

In the step S630, the control unit 130 determines the SOC of the battery B in the current cycle to be equal to the second estimated SOC.

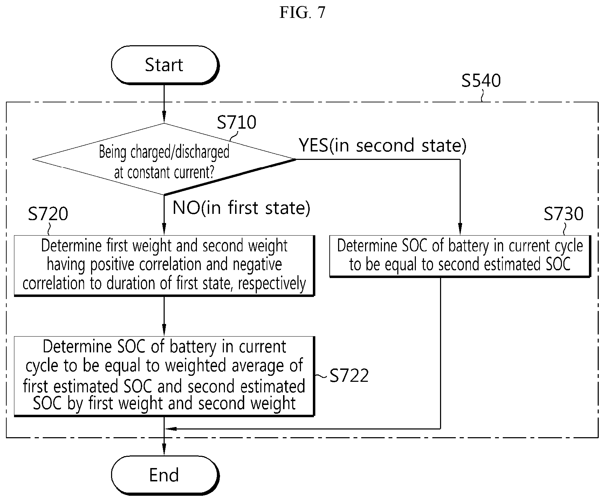

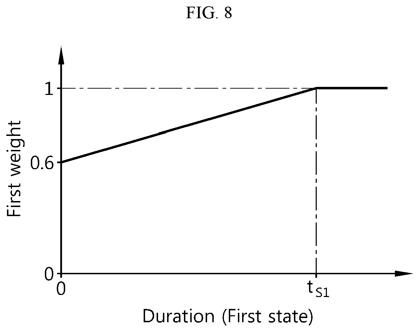

FIG. 7 is a flowchart exemplarily showing a battery management method for SOC estimation according to a third embodiment of the present disclosure, and FIG. 8 is a diagram used as a reference in describing the method according to FIG. 7. The method of FIG. 7 may be another example of the set of subroutines of the step S540 of the battery management method according to FIG. 5. That is, the third embodiment is a variation of the second embodiment.

Referring to FIG. 7, in step S710, the control unit 130 determines whether the battery B is being charged/discharged at a constant current based on the current value I[k] or the current time-series data indicating the time-dependent change history of the charge/discharge current. When a value of the step S710 is "NO", the process moves to step S720. When the value of the step S710 is "YES", the process moves to step S730.

In the step S720, the control unit 130 determines a first weight and a second weight having a positive correlation and a negative correlation to the duration of the first state, respectively. The first weight may be larger than the second weight. The sum of the first weight and the second weight may be a preset constant (for example, 1). In this case, when any one of the first weight and the second weight is determined, the remaining one may be also determined.

FIG. 8 is a graph exemplarily showing a change in the first weight as a function of the duration of the first state. Referring to FIG. 8, it shows that the minimum value of the first weight is 0.6, in the time range 0~t_{S1}, as the duration of the first state increases, the first weight increases, and from the time when the duration of the first state reaches a first reference time t_{S1}, the first weight is constantly maintained at 1.

In step S722, the control unit 130 determines the SOC of the battery B in the current cycle to be equal to the weighted average of the first estimated SOC and the second estimated SOC by the first weight and the second weight. As an example, where the first weight = 0.8, the second weight = 1 - the first weight = 0.2, the first estimated SOC = 0.60, the second estimated SOC = 0.62, the weighted average = (0.8*0.60) + (0.2*0.62) = 0.604. That is, the SOC of the battery B in the current cycle may be determined to be 60.4%.

In step S730, the control unit 130 determines the SOC of the battery B in the current cycle to be equal to the second estimated SOC.

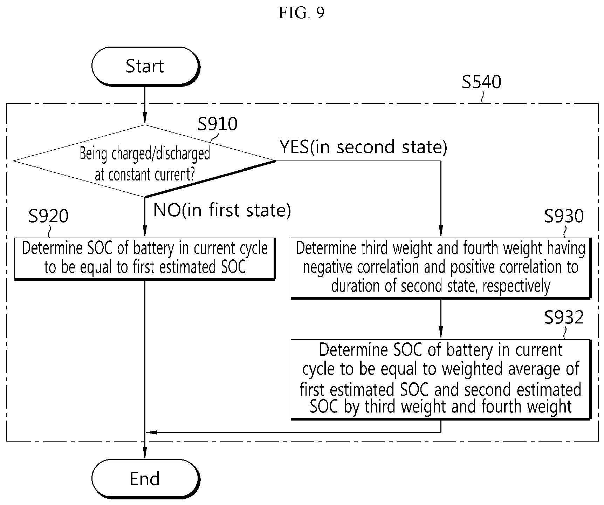

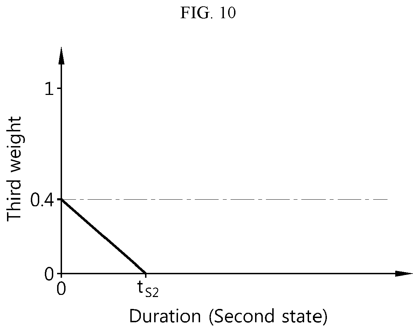

FIG. 9 is a flowchart exemplarily showing a battery management method for SOC estimation according to a fourth embodiment of the present disclosure, and FIG. 10 is a diagram used as a reference in describing the method according to FIG. 9. The method of FIG.9 may be another example of the set of subroutines of the step S540 of the battery management method according to FIG. 5. That is, the fourth embodiment is an additional variation of the second embodiment.

Referring to FIG. 9, in step S910, the control unit 130 determines whether the battery B is being charged/discharged at a constant current based on the current value or the current time-series data indicating the time-dependent change history of the charge/discharge current. When a value of the step S910 is "NO", the process moves to step S920. When the value of the step S910 is "YES", the process moves to step S930.

In the step S920, the control unit 130 determines the SOC of the battery B in the current cycle to be equal to the first estimated SOC.

In the step S930, the control unit 130 determines a third weight and a fourth weight having a negative correlation and a positive correlation to the duration of the second state, respectively. The third weight may be smaller than the fourth weight. The sum of the third weight and the fourth weight may be a preset constant (for example, 1). In this case, when any one of the third weight and the fourth weight is determined, the remaining one may be also determined.

FIG. 10 is a graph exemplarily showing a change in the third weight as a function of the duration of the second state. Referring to FIG. 10, it shows that the maximum value of the third weight is 0.4, in the time range (0~t_{S2}), as the duration of the second state increases, the third weight decreases, and from the time when the duration of the second state reaches a second reference time t_{S2}, the third weight is constantly maintained at 0.

In step S932, the control unit 130 determines the SOC of the battery B in the current cycle to be equal to the weighted average of the first estimated SOC and the second estimated SOC by the third weight and the fourth weight. As an example, where the third weight = 0.1, the fourth weight = 1 - the third weight = 0.9, the first estimated SOC = 0.60, the second estimated SOC = 0.62, the weighted average = (0.1*0.60) + (0.9*0.62) = 0.618. That is, the SOC of the battery B in the current cycle may be determined to be 61.8%.

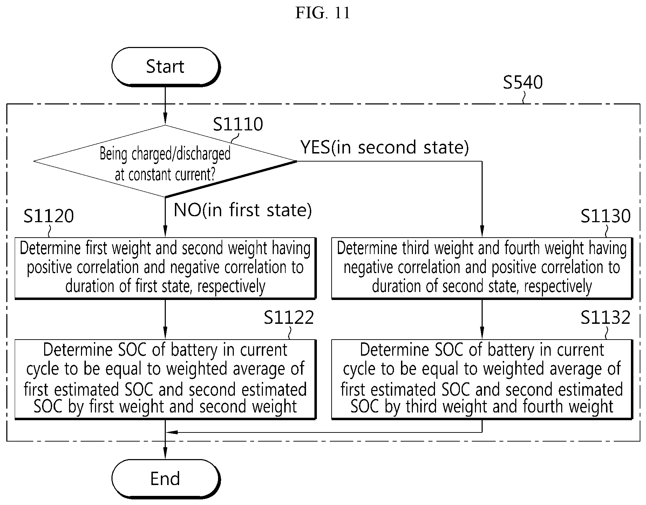

FIG. 9 is a flowchart exemplarily showing a battery management method for SOC estimation according to a fifth embodiment of the present disclosure. The method of FIG. 11 may be another example of the set of subroutines of the step S540 of the battery management method according to FIG. 5. That is, the fifth embodiment is an additional variation of the second embodiment.

Referring to FIG. 11, in step S1110, the control unit 130 determines whether the battery B is being charged/discharged at a constant current based the current value or on the current time-series data indicating the time-dependent change history of the charge/discharge current. When a value of the step S1110 is "NO", the process moves to step S1120. When the value of the step S1110 is "YES", the process moves to step S1130.

In the step S1120, the control unit 130 determines the first weight and the second weight having a positive correlation and a negative correlation to the duration of the first state, respectively.

In step S1122, the control unit 130 determines the SOC of the battery B in the current cycle to be equal to the weighted average of the first estimated SOC and the second estimated SOC by the first weight and the second weight.

The step S1120 and the step S1122 are the same as the step S720 and the step S722 of FIG. 7.

In the step S1130, the control unit 130 determines the third weight and the fourth weight having a negative correlation and a positive correlation to the duration of the second state, respectively.

In step S1132, the control unit 130 determines the SOC of the battery B in the current cycle to be equal to the weighted average of the first estimated SOC and the second estimated SOC by the third weight and the fourth weight.

The step S1130 and the step S1132 are the same as the step S930 and the step S932 of FIG. 9.

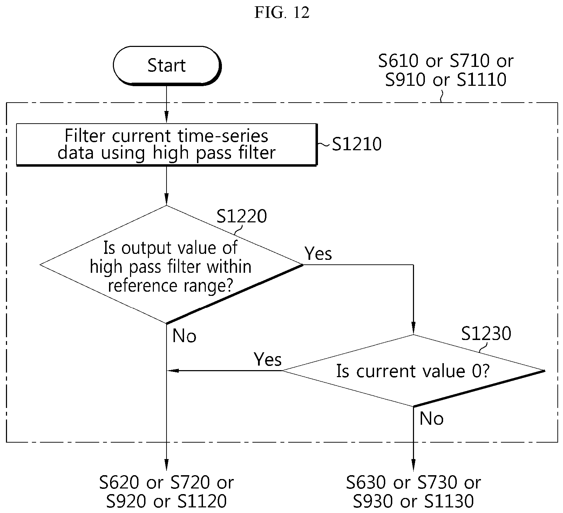

FIG. 12 is a flowchart exemplarily showing a method for determining whether the battery is being charged/discharged at a constant current. The method of FIG. 12 may be the set of subroutines of at least one of the step S610 of FIG. 6, the step S710 of FIG. 7, the step S910 of FIG. 9 or the step S1110 of FIG. 11.

In step S1210, the control unit 130 filters the current time-series data using a High Pass Filter (HPF). The high pass filter is a filter that removes a signal component that is smaller than a predetermined cutoff frequency, and allows a signal component that is larger than the cutoff frequency to pass therethrough. When the battery B is in the second state or at rest, the output value of the high path filter may be 0, and in other states, the output value of the high pass filter may not be 0. As fluctuations of the current flowing in the battery B are smaller, the output value of the high pass filter is closer to 0.

In step S1220, the control unit 130 determines whether the output value of the high pass filter lies in a reference range (for example, -0.001 to 0.001). When a value of the step S1220 is "YES", the process may move to step S1230. The reference range may be properly preset in view of the filtering precision of the high pass filter and the detection precision of the current detection unit 113. When the value of the step S1220 is "NO", the process moves to any one of the step S620 of FIG. 6, the step S720 of FIG. 7, the step S910 of FIG. 9 and the step S1120 of FIG. 11.

In the step S1230, the control unit 130 determines whether or not the current value is 0 [A]. When a value of the step S1230 is "YES", the process moves to any one of the step S620 of FIG. 6, the step S720 of FIG. 7, the step S910 of FIG. 9 and the step S1120 of FIG. 11. When the value of the step S1230 is "NO", the process moves to any one of the step S630 of FIG. 6, the step S730 of FIG. 7, the step S930 of FIG. 9 or the step S1130 of FIG. 11.

Although the step S610 of FIG. 6, the step S710 of FIG. 7, the step S910 of FIG. 9 and the step S1110 of FIG. 11 have been described as the subroutines of the step S540, it should be understood as an example. For example, at least one of the step S610 of FIG. 6, the step S710 of FIG. 7, the step S910 of FIG. 9 or the step S1110 of FIG. 11 may be performed using the current value determined in the step S510 before the step S520 or step S530 of FIG. 5 is performed.

The embodiments of the present disclosure described hereinabove are not implemented only through the apparatus and method, and may be implemented through programs that realize the functions corresponding to the configurations of the embodiments of the present disclosure or recording media having the programs recorded thereon, and such implementation may be easily achieved by those skilled in the art from the disclosure of the embodiments previously described.

While the present disclosure has been hereinabove described with regard to a limited number of embodiments and drawings, the present disclosure is not limited thereto and it is obvious to those skilled in the art that various modifications and changes may be made thereto within the technical aspect of the present disclosure and the scope of the appended claims.

Additionally, as many substitutions, modifications and changes may be made to the present disclosure by those skilled in the art without departing from the technical aspect of the present disclosure, the present disclosure is not limited by the foregoing embodiments and the accompanying drawings, and some or all of the embodiments may be selectively combined to make various modifications to the present disclosure.

## Claims

1. A battery management system (100) for a battery (B) having a characteristic that a voltage variation section changes depending on a current rate, the battery management system comprising:
a sensing unit configured to detect a terminal voltage and a charge/discharge current of the battery;
a memory unit (140) configured to store a first Kalman filter which is a state of charge (SOC) estimation logic using an equivalent circuit model and an SOC-open circuit voltage (OCV) curve of the battery and a second Kalman filter which is an SOC estimation logic using a constant current charge/discharge map (400) of the battery; and
a control unit (130) configured to determine a voltage value of the detected terminal voltage and a current value of the detected charge/discharge current,
wherein the control unit is configured to:
determine a first estimated SOC by inputting the voltage value, the current value and an estimated SOC in a previous cycle to the first Kalman filter,
determine a second estimated SOC by inputting the current value and the estimated SOC in the previous cycle to the second Kalman filter, and
determine an SOC of the battery in a current cycle based on at least one of the first estimated SOC or the second estimated SOC.

2. The battery management system (100) according to claim 1, wherein the control unit (130) is configured to:
determine whether the battery (B) is in a first state in which the battery is not being charged/discharged at a constant current or a second state in which the battery is being charged/discharged at the constant current based on the current value or current time-series data indicating a time-dependent change history of the charge/discharge current,
determine the SOC of the battery in the current cycle to be equal to the first estimated SOC in response to the determination that the battery is in the first state, and
determine the SOC of the battery in the current cycle to be equal to the second estimated SOC in response to the determination that the battery is in the second state.

3. The battery management system (100) according to claim 1, wherein the control unit (130) is configured to:
determine whether the battery (B) is in a first state in which the battery is not being charged/discharged at a constant current or a second state in which the battery is being charged/discharged at the constant current based on the current value or current time-series data indicating a time-dependent change history of the charge/discharge current,
determine a first weight having a positive correlation to a duration of the first state and a second weight having a negative correlation to the duration of the first state in response to the determination that the battery is in the first state, and
determine the SOC of the battery in the current cycle to be equal to a weighted average of the first estimated SOC and the second estimated SOC by the first weight and the second weight.

4. The battery management system (100) according to claim 3, wherein the first weight is larger than the second weight, and
wherein a sum of the first weight and the second weight is 1.

5. The battery management system (100) according to claim 1, wherein the control unit (130) is configured to:
determine whether the battery (B) is in a first state in which the battery is not being charged/discharged at a constant current or a second state in which the battery is being charged/discharged at the constant current based on the current value or current time-series data indicating a time-dependent change history of the charge/discharge current,
determine a third weight having a negative correlation to a duration of the second state and a fourth weight having a positive correlation to the duration of the second state in response to the determination that the battery is in the second state, and
determine a weighted average of the first estimated SOC and the second estimated SOC by the third weight and the fourth weight as the SOC of the battery in the current cycle.

6. The battery management system (100) according to claim 5, wherein the third weight is smaller than the fourth weight, and
wherein a sum of the third weight and the fourth weight is 1.

7. The battery management system (100) according to claim 1, wherein the constant current charge/discharge map (400) includes:
a plurality of charge curves (411, 412, 413, 414, 415, 416) indicating a relationship between the SOC and the voltage of the battery during constant current charging using a plurality of current rates; and
a plurality of discharge curves (421, 422, 423, 424, 425, 426) indicating a relationship between the SOC and the voltage of the battery during constant current discharging using the plurality of current rates, and
wherein the second estimated SOC is outputted from the second Kalman filter in response to any one curve of the plurality of charge curves and the plurality of discharge curves being provided to the second Kalman filter.

8. The battery management system (100) according to claim 7, wherein the control unit (130) is configured to:
provide the second Kalman filter with any one charge curve associated with the current rate corresponding to the current value among the plurality of charge curves in response to the battery being charged at the constant current, and
provide the second Kalman filter with any one discharge curve associated with the current rate corresponding to the current value among the plurality of discharge curves in response to the battery being discharged at the constant current.

9. A battery pack (10) comprising the battery management system (100) according to any one of claims 1 to 8.

10. An electric vehicle (1) comprising the battery pack (10) according to claim 9.

11. A battery management method for a battery (B) having a characteristic that a voltage variation section changes depending on a current rate, the battery management method comprising:
detecting (S510) a terminal voltage and a charge/discharge current of the battery and determining a voltage value of the detected terminal voltage and a current value of the detected charge/discharge current;
determining (S520) a first estimated SOC by inputting the voltage value, the current value and an estimated state of charge (SOC) in a previous cycle to a first Kalman filter which is an SOC estimation logic using an equivalent circuit model and an SOC-open circuit voltage (OCV) curve of the battery;
determining (S530) a second estimated SOC by inputting the current value and the estimated SOC in the previous cycle to a second Kalman filter which is an SOC estimation logic using a constant current charge/discharge map of the battery; and
determining (S540) an SOC of the battery in a current cycle based on at least one of the first estimated SOC or the second estimated SOC.

12. The battery management method according to claim 11, wherein the determining (S540) of the SOC of the battery in the current cycle comprises:
determining (S610) whether the battery is in a first state in which the battery is not being charged/discharged at a constant current or a second state in which the battery is being charged/discharged at the constant current based on the current value or current time-series data indicating a time-dependent change history of the charge/discharge current;
determining (S620) the first estimated SOC as the SOC of the battery in the current cycle in response to the determination that the battery is in the first state; and
determining (S630) the second estimated SOC as the SOC of the battery in the current cycle in response to the determination that the battery is in the second state.

13. The battery management method according to claim 11, wherein the determining (S540) of the SOC of the battery in the current cycle comprises:
determining whether the battery is in a first state in which the battery is not being charged/discharged at a constant current or a second state in which the battery is being charged/discharged at the constant current based on the current value or current time-series data indicating a time-dependent change history of the charge/discharge current;
determining (S720) a first weight having a positive correlation to a duration of the first state and a second weight having a negative correlation to the duration of the first state in response to the determination that the battery is in the first state; and
determining (S722) a weighted average of the first estimated SOC and the second estimated SOC by the first weight and the second weight as the SOC of the battery in the current cycle.

14. The battery management method according to claim 11, wherein the determining (S540) of the SOC of the battery in the current cycle comprises:
determining (S910) whether the battery is in a first state in which the battery is not being charged/discharged at a constant current or a second state in which the battery is being charged/discharged at the constant current based on the current value or current time-series data indicating a time-dependent change history of the charge/discharge current;
determining (S930) a third weight having a negative correlation to a duration of the second state and a fourth weight having a positive correlation to the duration of the second state in response to the determination that the battery is in the second state; and
determining (S932) a weighted average of the first estimated SOC and the second estimated SOC by the third weight and the fourth weight as the SOC of the battery in the current cycle.

15. The battery management method according to claim 11, wherein the constant current charge/discharge map (400) includes:
a plurality of charge curves (411, 412, 413, 414, 415, 416) indicating a relationship between the SOC and the voltage of the battery during constant current charging using a plurality of current rates; and
a plurality of discharge curves (421, 422, 423, 424, 425, 426) indicating a relationship between the SOC and the voltage of the battery during constant current discharging using the plurality of current rates, and
wherein the second estimated SOC is outputted from the second Kalman filter in response to any one curve of the plurality of charge curves and the plurality of discharge curves being provided to the second Kalman filter.

## Patentansprüche

1. Batteriemanagementsystem (100) für eine Batterie (B) mit einer Eigenschaft, dass sich ein Spannungsänderungsabschnitt in Abhängigkeit von einer Stromrate ändert, wobei das Batteriemanagementsystem umfasst:
eine Erfassungseinheit, die dazu konfiguriert ist, eine Klemmenspannung und einen Lade-/Entladestrom der Batterie zu erfassen;
eine Speichereinheit (140), die dazu konfiguriert ist, einen ersten Kalman-Filter, der eine Ladezustands(SOG)-Schätzlogik ist, die ein Ersatzschaltbildmodell und eine SOC-Leerlaufspannungskurve (OCV-Kurve) der Batterie verwendet, und einen zweiten Kalman-Filter, der eine SOC-Schätzlogik ist, die ein Konstantstrom-Lade-/Entladekennfeld (400) der Batterie verwendet, zu speichern; und
eine Steuereinheit (130), die dazu konfiguriert ist, einen Spannungswert der erfassten Klemmenspannung und einen Stromwert des erfassten Lade-/Entladestroms zu bestimmen,
wobei die Steuereinheit zu Folgendem konfiguriert ist:
Bestimmen eines ersten geschätzten SOC durch Eingabe des Spannungswertes, des Stromwertes und eines geschätzten SOC in einem vorherigen Zyklus in den ersten Kalman-Filter,
Bestimmen eines zweiten geschätzten SOC durch Eingabe des Stromwertes und des geschätzten SOC im vorherigen Zyklus in den zweiten Kalman-Filter, und
Bestimmen eines SOC der Batterie in einem aktuellen Zyklus basierend auf mindestens einem von dem ersten geschätzten SOC oder dem zweiten geschätzten SOC.

2. Batteriemanagementsystem (100) nach Anspruch 1, wobei die Steuereinheit (130) zu Folgendem konfiguriert ist:
Bestimmen, ob sich die Batterie (B) in einem ersten Zustand befindet, in dem die Batterie nicht mit einem Konstantstrom geladen/entladen wird, oder in einem zweiten Zustand, in dem die Batterie mit dem Konstantstrom geladen/entladen wird, basierend auf dem Stromwert oder aktuellen Zeitreihendaten, die einen zeitabhängigen Änderungsverlauf des Lade-/Entladestroms angeben,
Bestimmen des SOC der Batterie im aktuellen Zyklus als gleich dem ersten geschätzten SOC in Reaktion auf die Bestimmung, dass sich die Batterie im ersten Zustand befindet, und
Bestimmen des SOC der Batterie im aktuellen Zyklus als gleich dem zweiten geschätzten SOC in Reaktion auf die Bestimmung, dass sich die Batterie im zweiten Zustand befindet.

3. Batteriemanagementsystem (100) nach Anspruch 1, wobei die Steuereinheit (130) zu Folgendem konfiguriert ist:
Bestimmen, ob sich die Batterie (B) in einem ersten Zustand befindet, in dem die Batterie nicht mit einem Konstantstrom geladen/entladen wird, oder in einem zweiten Zustand, in dem die Batterie mit dem Konstantstrom geladen/entladen wird, basierend auf dem Stromwert oder aktuellen Zeitreihendaten, die einen zeitabhängigen Änderungsverlauf des Lade-/Entladestroms angeben,
Bestimmen eines ersten Gewichts mit einer positiven Korrelation zu einer Dauer des ersten Zustands und eines zweiten Gewichts mit einer negativen Korrelation zur Dauer des ersten Zustands in Reaktion auf die Bestimmung, dass sich die Batterie im ersten Zustand befindet, und
Bestimmen des SOC der Batterie im aktuellen Zyklus als gleich einem gewichteten Durchschnitt des ersten geschätzten SOC und des zweiten geschätzten SOC durch das erste Gewicht und das zweite Gewicht.

4. Batteriemanagementsystem (100) nach Anspruch 3, wobei das erste Gewicht größer als das zweite Gewicht ist, und
wobei eine Summe des ersten Gewichts und des zweiten Gewichts 1 beträgt.

5. Batteriemanagementsystem (100) nach Anspruch 1, wobei die Steuereinheit (130) zu Folgendem konfiguriert ist:
Bestimmen, ob sich die Batterie (B) in einem ersten Zustand befindet, in dem die Batterie nicht mit einem Konstantstrom geladen/entladen wird, oder in einem zweiten Zustand, in dem die Batterie mit dem Konstantstrom geladen/entladen wird, basierend auf dem Stromwert oder aktuellen Zeitreihendaten, die einen zeitabhängigen Änderungsverlauf des Lade-/Entladestroms angeben,
Bestimmen eines dritten Gewichts mit einer negativen Korrelation zu einer Dauer des zweiten Zustands und eines vierten Gewichts mit einer positiven Korrelation zur Dauer des zweiten Zustands in Reaktion auf die Bestimmung, dass sich die Batterie im zweiten Zustand befindet, und
Bestimmen eines gewichteten Durchschnitts des ersten geschätzten SOC und des zweiten geschätzten SOC durch das dritte Gewicht und das vierte Gewicht als den SOC der Batterie im aktuellen Zyklus.

6. Batteriemanagementsystem (100) nach Anspruch 5, wobei das dritte Gewicht kleiner als das vierte Gewicht ist, und
wobei eine Summe des dritten Gewichts und des vierten Gewichts 1 beträgt.

7. Batteriemanagementsystem (100) nach Anspruch 1, wobei das Konstantstrom-Lade-/Entladekennfeld (400) enthält:
eine Vielzahl von Ladekurven (411, 412, 413, 414, 415, 416), die eine Beziehung zwischen dem SOC und der Spannung der Batterie während des Ladens mit Konstantstrom unter Verwendung einer Vielzahl von Stromraten angeben; und
eine Vielzahl von Entladekurven (421, 422, 423, 424, 425, 426), die eine Beziehung zwischen dem SOC und der Spannung der Batterie während des Entladens mit Konstantstrom unter Verwendung der Vielzahl von Stromraten angeben, und
wobei der zweite geschätzte SOC vom zweiten Kalman-Filter in Reaktion darauf ausgegeben wird, dass eine beliebige Kurve aus der Vielzahl von Ladekurven und der Vielzahl von Entladekurven dem zweiten Kalman-Filter bereitgestellt wird.

8. Batteriemanagementsystem (100) nach Anspruch 7, wobei die Steuereinheit (130) zu Folgendem konfiguriert ist:
Bereitstellen einer beliebigen Ladekurve, die der Stromrate entspricht, die dem Stromwert unter der Vielzahl von Ladekurven zugeordnet ist, an den zweiten Kalman-Filter in Reaktion darauf, dass die Batterie mit dem Konstantstrom geladen wird, und
Bereitstellen einer beliebigen Entladekurve, die der Stromrate entspricht, die dem Stromwert unter der Vielzahl von Entladekurven zugeordnet ist, an den zweiten Kalman-Filter in Reaktion darauf, dass die Batterie mit dem Konstantstrom entladen wird.

9. Batteriepack (10), umfassend das Batteriemanagementsystem (100) nach einem der Ansprüche 1 bis 8.

10. Elektrofahrzeug (1), umfassend den Batteriepack (10) nach Anspruch 9.

11. Batteriemanagementverfahren für eine Batterie (B) mit einer Eigenschaft, dass sich ein Spannungsänderungsabschnitt in Abhängigkeit von einer Stromrate ändert, wobei das Batteriemanagementverfahren umfasst:
Erfassen (S510) einer Klemmenspannung und eines Lade-/Entladestroms der Batterie und Bestimmen eines Spannungswertes der erfassten Klemmenspannung und eines Stromwertes des erfassten Lade-/Entladestroms;
Bestimmen (S520) eines ersten geschätzten SOC durch Eingabe des Spannungswertes, des Stromwertes und eines geschätzten Ladezustands (SOC) in einem vorherigen Zyklus in einen ersten Kalman-Filter, der eine SOC-Schätzlogik ist, die ein Ersatzschaltbildmodell und eine SOC-Leerlaufspannungs-Kurve (OCV-Kurve) der Batterie verwendet;
Bestimmen (S530) eines zweiten geschätzten SOC durch Eingabe des Stromwertes und des geschätzten SOC im vorherigen Zyklus in einen zweiten Kalman-Filter, der eine SOC-Schätzlogik ist, die ein Konstantstrom-Lade-/Entladekennfeld der Batterie verwendet; und
Bestimmen (S540) eines SOC der Batterie in einem aktuellen Zyklus basierend auf mindestens einem von dem ersten geschätzten SOC oder dem zweiten geschätzten SOC.

12. Batteriemanagementverfahren nach Anspruch 11, wobei das Bestimmen (S540) des SOC der Batterie im aktuellen Zyklus umfasst:
Bestimmen (S610), ob sich die Batterie in einem ersten Zustand befindet, in dem die Batterie nicht mit einem Konstantstrom geladen/entladen wird, oder in einem zweiten Zustand, in dem die Batterie mit dem Konstantstrom geladen/entladen wird, basierend auf dem Stromwert oder aktuellen Zeitreihendaten, die einen zeitabhängigen Änderungsverlauf des Lade-/Entladestroms angeben;
Bestimmen (S620) des ersten geschätzten SOC als den SOC der Batterie im aktuellen Zyklus in Reaktion auf die Bestimmung, dass sich die Batterie im ersten Zustand befindet; und
Bestimmen (S630) des zweiten geschätzten SOC als den SOC der Batterie im aktuellen Zyklus in Reaktion auf die Bestimmung, dass sich die Batterie im zweiten Zustand befindet.

13. Batteriemanagementverfahren nach Anspruch 11, wobei das Bestimmen (S540) des SOC der Batterie im aktuellen Zyklus umfasst:
Bestimmen, ob sich die Batterie in einem ersten Zustand befindet, in dem die Batterie nicht mit einem Konstantstrom geladen/entladen wird, oder in einem zweiten Zustand, in dem die Batterie mit dem Konstantstrom geladen/entladen wird, basierend auf dem Stromwert oder aktuellen Zeitreihendaten, die einen zeitabhängigen Änderungsverlauf des Lade-/Entladestroms angeben;
Bestimmen (S720) eines ersten Gewichts mit einer positiven Korrelation zu einer Dauer des ersten Zustands und eines zweiten Gewichts mit einer negativen Korrelation zur Dauer des ersten Zustands in Reaktion auf die Bestimmung, dass sich die Batterie im ersten Zustand befindet; und
Bestimmen (S722) eines gewichteten Durchschnitts des ersten geschätzten SOC und des zweiten geschätzten SOC durch das erste Gewicht und das zweite Gewicht als den SOC der Batterie im aktuellen Zyklus.

14. Batteriemanagementverfahren nach Anspruch 11, wobei das Bestimmen (S540) des SOC der Batterie im aktuellen Zyklus umfasst:
Bestimmen (S910), ob sich die Batterie in einem ersten Zustand befindet, in dem die Batterie nicht mit einem Konstantstrom geladen/entladen wird, oder in einem zweiten Zustand, in dem die Batterie mit dem Konstantstrom geladen/entladen wird, basierend auf dem Stromwert oder aktuellen Zeitreihendaten, die einen zeitabhängigen Änderungsverlauf des Lade-/Entladestroms angeben;
Bestimmen (S930) eines dritten Gewichts mit einer negativen Korrelation zu einer Dauer des zweiten Zustands und eines vierten Gewichts mit einer positiven Korrelation zur Dauer des zweiten Zustands in Reaktion auf die Bestimmung, dass sich die Batterie im zweiten Zustand befindet; und
Bestimmen (S932) eines gewichteten Durchschnitts des ersten geschätzten SOC und des zweiten geschätzten SOC durch das dritte Gewicht und das vierte Gewicht als den SOC der Batterie im aktuellen Zyklus.

15. Batteriemanagementverfahren nach Anspruch 11, wobei das Konstantstrom-Lade-/Entladekennfeld (400) enthält:
eine Vielzahl von Ladekurven (411, 412, 413, 414, 415, 416), die eine Beziehung zwischen dem SOC und der Spannung der Batterie während des Ladens mit Konstantstrom unter Verwendung einer Vielzahl von Stromraten angeben; und
eine Vielzahl von Entladekurven (421, 422, 423, 424, 425, 426), die eine Beziehung zwischen dem SOC und der Spannung der Batterie während des Entladens mit Konstantstrom unter Verwendung der Vielzahl von Stromraten angeben, und
wobei der zweite geschätzte SOC vom zweiten Kalman-Filter in Reaktion darauf ausgegeben wird, dass eine beliebige Kurve aus der Vielzahl von Ladekurven und der Vielzahl von Entladekurven dem zweiten Kalman-Filter bereitgestellt wird.

## Revendications

1. Système de gestion de batterie (100) pour une batterie (B) ayant une caractéristique selon laquelle une section de variation de tension change en fonction d'un taux de courant, le système de gestion de batterie comprenant :
une unité de détection configurée pour détecter une tension aux bornes et un courant de charge/décharge de la batterie ;
une unité de mémoire (140) configurée pour stocker un premier filtre de Kalman qui est une logique d'estimation d'état de charge (SOC) utilisant un modèle de circuit équivalent et une courbe SOC-tension en circuit ouvert (OCV) de la batterie et un second filtre de Kalman qui est une logique d'estimation de SOC utilisant une carte de charge/décharge à courant constant (400) de la batterie ; et
une unité de commande (130) configurée pour déterminer une valeur de tension de la tension aux bornes détectée et une valeur de courant du courant de charge/décharge détecté,
dans lequel l'unité de commande est configurée pour :
déterminer un premier SOC estimé en entrant la valeur de tension, la valeur de courant et un SOC estimé dans un cycle précédent dans le premier filtre de Kalman,
déterminer un second SOC estimé en entrant la valeur de courant et le SOC estimé dans le cycle précédent dans le second filtre de Kalman, et
déterminer un SOC de la batterie dans un cycle actuel sur la base d'au moins l'un du premier SOC estimé ou du second SOC estimé.

2. Système de gestion de batterie (100) selon la revendication 1, dans lequel l'unité de commande (130) est configurée pour :
déterminer si la batterie (B) est dans un premier état dans lequel la batterie n'est pas en cours de charge/décharge à un courant constant ou un second état dans lequel la batterie est en cours de charge/décharge au courant constant sur la base de la valeur de courant ou de données de série temporelle de courant indiquant un historique de changement dépendant du temps du courant de charge/décharge,
déterminer que le SOC de la batterie dans le cycle actuel est égal au premier SOC estimé en réponse à la détermination que la batterie est dans le premier état, et
déterminer que le SOC de la batterie dans le cycle actuel est égal au second SOC estimé en réponse à la détermination que la batterie est dans le second état.

3. Système de gestion de batterie (100) selon la revendication 1, dans lequel l'unité de commande (130) est configurée pour :
déterminer si la batterie (B) est dans un premier état dans lequel la batterie n'est pas en cours de charge/décharge à un courant constant ou un second état dans lequel la batterie est en cours de charge/décharge au courant constant sur la base de la valeur de courant ou de données de série temporelle de courant indiquant un historique de changement dépendant du temps du courant de charge/décharge,
déterminer un premier poids ayant une corrélation positive avec une durée du premier état et un second poids ayant une corrélation négative avec la durée du premier état en réponse à la détermination que la batterie est dans le premier état, et
déterminer que le SOC de la batterie dans le cycle actuel est égal à une moyenne pondérée du premier SOC estimé et du second SOC estimé par le premier poids et le second poids.

4. Système de gestion de batterie (100) selon la revendication 3, dans lequel le premier poids est supérieur au second poids, et
dans lequel une somme du premier poids et du second poids est de 1.

5. Système de gestion de batterie (100) selon la revendication 1, dans lequel l'unité de commande (130) est configurée pour :
déterminer si la batterie (B) est dans un premier état dans lequel la batterie n'est pas en cours de charge/décharge à un courant constant ou un second état dans lequel la batterie est en cours de charge/décharge au courant constant sur la base de la valeur de courant ou de données de série temporelle de courant indiquant un historique de changement dépendant du temps du courant de charge/décharge,
déterminer un troisième poids ayant une corrélation négative avec une durée du second état et un quatrième poids ayant une corrélation positive avec la durée du second état en réponse à la détermination que la batterie est dans le second état, et
déterminer une moyenne pondérée du premier SOC estimé et du second SOC estimé par le troisième poids et le quatrième poids comme étant le SOC de la batterie dans le cycle actuel.

6. Système de gestion de batterie (100) selon la revendication 5, dans lequel le troisième poids est inférieur au quatrième poids, et
dans lequel une somme du troisième poids et du quatrième poids est de 1.

7. Système de gestion de batterie (100) selon la revendication 1, dans lequel la carte de charge/décharge à courant constant (400) inclut :
une pluralité de courbes de charge (411, 412, 413, 414, 415, 416) indiquant une relation entre le SOC et la tension de la batterie pendant une charge à courant constant en utilisant une pluralité de taux de courant ; et
une pluralité de courbes de décharge (421, 422, 423, 424, 425, 426) indiquant une relation entre le SOC et la tension de la batterie pendant une décharge à courant constant en utilisant la pluralité de taux de courant, et
dans lequel le second SOC estimé est délivré en sortie par le second filtre de Kalman en réponse à la fourniture de l'une quelconque des courbes de la pluralité de courbes de charge et de la pluralité de courbes de décharge au second filtre de Kalman.

8. Système de gestion de batterie (100) selon la revendication 7, dans lequel l'unité de commande (130) est configurée pour :
fournir au second filtre de Kalman l'une quelconque des courbes de charge associée au taux de courant correspondant à la valeur de courant parmi la pluralité de courbes de charge en réponse au fait que la batterie est en cours de charge au courant constant, et
fournir au second filtre de Kalman l'une quelconque des courbes de décharge associée au taux de courant correspondant à la valeur de courant parmi la pluralité de courbes de décharge en réponse au fait que la batterie est en cours de décharge au courant constant.

9. Bloc-batterie (10) comprenant le système de gestion de batterie (100) selon l'une quelconque des revendications 1 à 8.

10. Véhicule électrique (1) comprenant le bloc-batterie (10) selon la revendication 9.

11. Procédé de gestion de batterie pour une batterie (B) ayant une caractéristique selon laquelle une section de variation de tension change en fonction d'un taux de courant, le procédé de gestion de batterie comprenant :
la détection (S510) d'une tension aux bornes et d'un courant de charge/décharge de la batterie et la détermination d'une valeur de tension de la tension aux bornes détectée et d'une valeur de courant du courant de charge/décharge détecté ;
la détermination (S520) d'un premier SOC estimé en entrant la valeur de tension, la valeur de courant et un état de charge (SOC) estimé dans un cycle précédent dans un premier filtre de Kalman qui est une logique d'estimation de SOC utilisant un modèle de circuit équivalent et une courbe SOC-tension en circuit ouvert (OCV) de la batterie ;
la détermination (S530) d'un second SOC estimé en entrant la valeur de courant et le SOC estimé dans le cycle précédent dans un second filtre de Kalman qui est une logique d'estimation de SOC utilisant une carte de charge/décharge à courant constant de la batterie ; et
la détermination (S540) d'un SOC de la batterie dans un cycle actuel sur la base d'au moins l'un du premier SOC estimé ou du second SOC estimé.

12. Procédé de gestion de batterie selon la revendication 11, dans lequel la détermination (S540) du SOC de la batterie dans le cycle actuel comprend :
la détermination (S610) du fait que la batterie est dans un premier état dans lequel la batterie n'est pas en cours de charge/décharge à un courant constant ou un second état dans lequel la batterie est en cours de charge/décharge au courant constant sur la base de la valeur de courant ou de données de série temporelle de courant indiquant un historique de changement dépendant du temps du courant de charge/décharge ;
la détermination (S620) du premier SOC estimé comme étant le SOC de la batterie dans le cycle actuel en réponse à la détermination que la batterie est dans le premier état ; et
la détermination (S630) du second SOC estimé comme étant le SOC de la batterie dans le cycle actuel en réponse à la détermination que la batterie est dans le second état.

13. Procédé de gestion de batterie selon la revendication 11, dans lequel la détermination (S540) du SOC de la batterie dans le cycle actuel comprend :
la détermination du fait que la batterie est dans un premier état dans lequel la batterie n'est pas en cours de charge/décharge à un courant constant ou un second état dans lequel la batterie est en cours de charge/décharge au courant constant sur la base de la valeur de courant ou de données de série temporelle de courant indiquant un historique de changement dépendant du temps du courant de charge/décharge ;
la détermination (S720) d'un premier poids ayant une corrélation positive avec une durée du premier état et d'un second poids ayant une corrélation négative avec la durée du premier état en réponse à la détermination que la batterie est dans le premier état ; et
la détermination (S722) d'une moyenne pondérée du premier SOC estimé et du second SOC estimé par le premier poids et le second poids comme étant le SOC de la batterie dans le cycle actuel.

14. Procédé de gestion de batterie selon la revendication 11, dans lequel la détermination (S540) du SOC de la batterie dans le cycle actuel comprend :
la détermination (S910) du fait que la batterie est dans un premier état dans lequel la batterie n'est pas en cours de charge/décharge à un courant constant ou un second état dans lequel la batterie est en cours de charge/décharge au courant constant sur la base de la valeur de courant ou de données de série temporelle de courant indiquant un historique de changement dépendant du temps du courant de charge/décharge ;
la détermination (S930) d'un troisième poids ayant une corrélation négative avec une durée du second état et d'un quatrième poids ayant une corrélation positive avec la durée du second état en réponse à la détermination que la batterie est dans le second état ; et
la détermination (S932) d'une moyenne pondérée du premier SOC estimé et du second SOC estimé par le troisième poids et le quatrième poids comme étant le SOC de la batterie dans le cycle actuel.

15. Procédé de gestion de batterie selon la revendication 11, dans lequel la carte de charge/décharge à courant constant (400) inclut :
une pluralité de courbes de charge (411, 412, 413, 414, 415, 416) indiquant une relation entre le SOC et la tension de la batterie pendant une charge à courant constant en utilisant une pluralité de taux de courant ; et
une pluralité de courbes de décharge (421, 422, 423, 424, 425, 426) indiquant une relation entre le SOC et la tension de la batterie pendant une décharge à courant constant en utilisant la pluralité de taux de courant, et
dans lequel le second SOC estimé est délivré en sortie par le second filtre de Kalman en réponse à la fourniture de l'une quelconque des courbes de la pluralité de courbes de charge et de la pluralité de courbes de décharge au second filtre de Kalman.
